(19) Europäisches Patentamt / European Patent Office / Office européen des brevets

(11) **EP 1 347 569 B1**

(12) **EUROPÄISCHE PATENTSCHRIFT**

(45) Veröffentlichungstag und Bekanntmachung des Hinweises auf die Patenterteilung:
**19.03.2008 Patentblatt 2008/12**

(51) Int Cl.:
*H03D 3/00* (2006.01)  *H04B 1/10* (2006.01)

(21) Anmeldenummer: **02028308.1**

(22) Anmeldetag: **17.12.2002**

(54) **Verfahren und Vorrichtung zum Detektieren von Empfangsstörungen eines digitalen FM-Empfängers**

Method and device for detection of reception disturbances in a digital FM-receiver

Méthode et dispositif pour détecter des perturbations de réception dans un récepteur M.F. de radio-diffusion numérique

(84) Benannte Vertragsstaaten:
**DE FR IT SE**

(30) Priorität: **21.03.2002 DE 10212517**

(43) Veröffentlichungstag der Anmeldung:
**24.09.2003 Patentblatt 2003/39**

(73) Patentinhaber: **ROBERT BOSCH GMBH**
**70442 Stuttgart (DE)**

(72) Erfinder:
• **Risse, Marcus**
  **31137 Hildesheim (DE)**
• **Lehr, Carsten**
  **30451 Hannover (DE)**
• **Nyenhuis, Detlev**
  **31079 Sibbesse (DE)**

(56) Entgegenhaltungen:
**EP-A- 0 430 468**    **DE-A- 3 243 146**

**Beschreibung**

Die Erfindung betrifft ein Verfahren und eine Vorrichtung zum Detektieren von Empfangsstörungen eines digitalen FM-Empfängers.

Bei analogen Empfängern ist es bekannt, eine Detektion von Empfangsstörungen durch eine Auswertung von Signalanteilen des Amplitudensignals in einem Frequenzbereich um 19 kHz durchzuführen. Bei ungestörtem Empfang enthält der Frequenzbereich um 19 kHz nur geringe Signalanteile. Je größer die Signalanteile in diesem Frequenzbereich sind, desto höher ist die Wahrscheinlichkeit, dass eine Empfangsstörung vorliegt. Bei derartigen analogen Empfangskonzepten wird zur Detektion einer Empfangsstörung das Amplitudensignal logarithmiert und das so gebildete logarithmierte Amplitudensignal direkt ausgewertet. Durch die Logarithmierung wird näherungsweise eine Normierung auf den Gleichanteil des Amplitudensignals erreicht.

Einen ähnlichen Empfänger zeigt DE 3 243 146.

Eine derartige Auswertung eines logarithmierten Amplitudensignals bei 19 kHz ist bei digitalen Empfängern im allgemeinen kaum durchführbar, da der bei der Logarithmusberechnung erforderliche Rechenaufwand sehr hoch ist.

Weiterhin ist eine direkte Auswertung des Amplitudensignals eines demodulierten FM-Signals im allgemeinen nicht unproblematisch. Zwar hat ein derartiges Amplitudensignal idealerweise einen konstanten Wert. In der Realität ist aufgrund unterschiedlicher Einflüsse das Amplitudensignal nach der Demodulation jedoch nicht konstant. Derartige Amplitudenschwankungen werden in geringerem Umfang unter anderem durch Einflüsse der Signalverarbeitung, z. B. die Verwendung eines ZF-Filters vor der Demodulation, und in stärkerem Umfang durch nicht ideale Empfangsbedingungen, z. B. Mehrwegeausbreitung, verursacht. Somit ist die Detektion, insbesondere eine quantitative Abschätzung des Ausmaßes von Empfangsstörungen eines digitalen FM-Empfängers, derzeit in der Regel zu aufwendig, um sie in größerem Umfang durchführen zu können.

Das erfindungsgemäße Verfahren nach Anspruch 1 und die erfindungsgemäße Vorrichtung nach Anspruch 20 bieten demgegenüber insbesondere den Vorteil, Empfangsstörungen eines digitalen FM-Empfängers mit relativ hoher Genauigkeit und dennoch relativ geringem Aufwand bei einem digitalen FM-Empfänger detektieren und quantitativ abschätzen zu können. Die Unteransprüche beschreiben bevorzugte Weiterbildungen.

Bei dem erfindungsgemäßen Verfahren können die Schritte a) und d) und die Schritte b) und c) grundsätzlich in beliebiger Reihenfolge erfolgen.

Erfindungsgemäß wird somit - analog wie bei der Detektion von Empfangsstörungen in analogen Empfängern - eine Auswertung der Signalanteile in einem geeigneten Frequenzbereich, insbesondere bei einer Referenzfrequenz um 19 kHz herum, durchgeführt. Grundsätzlich können erfindungsgemäß jedoch auch andere Frequenzbereiche gewählt werden, bei denen nur geringe Signalanteile zu erwarten sind, z. B. auch unterhalb von 17 kHz und/oder oberhalb von 20 kHz; weiterhin kann ein Frequenzbereich ausgewählt werden, von dem anzunehmen ist, dass sein Signalanteil in einem vorbekannten Wertebereich liegt, so dass Abweichungen von diesem Wertebereich - z. B. in einem zeitlichen Mittel - ausgewertet werden. Erfindungsgemäß wird ein frequenzspezifisches Amplitudennäherungssignal ermittelt und auf den Frequenzhub des frequenzmodulierten Signals und den Mittelwert bzw. Gleichanteil des Amplitudensignals normiert, um die Beeinflussung der Größe der relevanten Signalanteile durch weitere Einflüsse zu minimieren. Insbesondere durch die Normierung auf den Frequenzhub wird erfindungsgemäß eine hohe Genauigkeit erreicht.

Der Erfindung liegt weiterhin die Erkenntnis zugrunde, dass eine Detektion und quantitative Abschätzung von Empfangsstörungen nicht eine genaue Berechnung der normierten Frequenzanteile erfordern, sondern eine Ermittlung entsprechendet Näherungswerte oder Referenzwerte ausreichend und vorteilhaft ist, die eine geeignete Näherung oder Abschätzung des betreffenden Werte zulassen.

Dementsprechend wird erfindungsgemäß aus dem Amplitudensignals nicht unbedingt der genaue Wert der Amplitude in dem Frequenzbereich ermittelt, sondern es reicht die Ermittlung eines Näherungswertes, der ein Maß für die Amplitude in dem betreffenden Frequenzbereich darstellt.

Weiterhin können vorteilhafterweise bei der Normierung des frequenzspezifischen Amplitudennäherungssignals Näherungskehrwerte anstelle genauer Kehrwerte des Gleichanteils und des Frequenzhubs gebildet werden, die z. B. durch eine rekursive Berechnungsvorschrift aus einer Folge abgetasteter Werte, vorzugsweise unterabgetasteter Werte, ermittelt werden. Die Berechnung der Näherungskehrwerte wird vorteilhafterweise zur Vereinfachung einer hardwaremäßigen Realisierung mittels Shift-operationen durchgeführt.

Auch bei den anderen Berechnungen bzw. Ermittlungen können erfindungsgemäß Näherungswerte bzw. Referenzwerte anstelle genauer Werte ermittelt werden. Die Tiefpässe dienen allgemein der Glättung der betreffenden Signale, d.h. des frequenzspezifischen Amplitudennäherungssignals, des Gleichanteilsignals und des Frequenzhubsignals. Hierbei können unterschiedliche Tiefpässe verwendet werden; vorteilhafterweise werden bei diesen Tiefpässen oder einem Teil der Tiefpässe Unterabtastungen zur Reduzierung des Rechenaufwandes vorgenommen; weiterhin können insbesondere bei der Ermittlung des FAM und des GAM Spitzenwertgleichrichter zur Ermittlung der oberen bzw. unteren Hüllkurve verwendet werden.

In der frequenzselektiven amplitudenermittelnden Einrichtung kann bei dem Schritt b) das Amplitudensignal mit einem Sinus-Hilfssignal der Referenzfrequenz oder auch mit mehreren, z. B. zwei phasenverschobenen Sinus-Hilfssignalen multipliziert werden, die nachfolgend nach Betragsbildung und weiterer Glättung addiert werden. Duch die Multiplikationen werden die Signalanteile bei der Referenzfrequenz in ein Basisband gemischt.

Die Erfindung wird im folgenden anhand der beiliegenden Zeichnungen an einigen Ausführungsformen erläutert. Es zeigen:

Fig. 1 ein Blockschaltbild einer Vorrichtung zum Detektieren von Empfangsstörungen eines digitalen FM-Empfängers gemäß einer Ausführungsform;
Fig. 2 ein Blockschaltbild einer erfindungsgemäßen Invertierungseinrichtung gemäß einer weiteren Ausführungsform.

Ein frequenzmoduliertes digitales Eingangssignal, z. B. ein Stereo-Multiplexsignal MPX, wird in an sich bekannter Weise in einer Demodulationseinrichtung 2 in ein Amplitudensignal AM demoduliert. Anstelle eines Stereo-Multiplexsignals MPX kann erfindungsgemäß auch ein anderes FM-Signal untersucht werden. Das Amplitudensignal AM wird nachfolgend einer frequenzselektiven Amplitudenermittlungseinrichtung 3 zugeführt, die ein frequenzspezifisches Amplitudennäherungssignal FAM ermittelt und an eine Normierungseinrichtung 6 ausgibt. Weiterhin wird das Amplitudensignal AM einer Gleichanteil-Bestimmungseinrichtung 4 eingegeben, die einen Gleichanteil bzw. Mittelwert berechnet und als Gleichanteilsignal GAM an die Normierungseinrichtung 6 ausgibt. Das frequenzmodulierte Eingangssignal MPX wird weiterhin an eine frequenzhubermittelnde Einrichtung 5 gegeben, die einen Frequenzhub ermittelt und als Frequenzhubsignal FH an die Normierungseinrichtung 6 ausgibt. Die Normierungseinrichtung 6 normiert das frequenzspezifische Amplitudennäherungssignal FAM in Abhängigkeit von den Signalen GAM und FH und gibt ein Störungsdetektionssignal S aus.

In der frequenzselektiven Amplitudenermittlungseinrichtung 3 wird im wesentlichen eine Synchrongleichrichtung durchgeführt. Hierzu wird das Amplitudensignal AM in einem ersten Multiplizierer 31 mit dem ersten Sinus-Hilfssignal sin(19kHz∗t) und in einem zweiten Multiplizierer mit dem zweiten Sinus-Hilfssignal cos(19kHz∗t) multipliziert. So gebildeten Produktsignale p1, p2 der Multiplizierer 31 und 34 werden in einem ersten bzw. zweiten Tiefpass 32, 35 tiefpassgefiltert, wodurch die Bandbreite der beiden Mischsignale begrenzt wird; hierbei wird eine erste Unterabtastung von 1: N, mit z. B. N=24, vorgenommen, um die Abtastfrequenz des Eingangssignals von z. B. fa=228 kHz auf eine niedrigere Abtastrequenz von z. B. fb=9.5 kHz herabzusetzen und hierdurch den Rechenaufwand zu verringern. Die so gebildeten Ausgangssignale werden an betragsbildende Einrichtungen 33 und 36 ausgegeben, in denen jeweils Betragssignale b1, b2 ermittelt werden, die in der ersten Additionseinrichtung 37 addiert werden. Durch das so gebildete Additionssignal a wird bereits ein Näherungswert zur Abschätzung des Betrages des Amplitudensignals im Frequenzbereich um 19 kHz ermittelt. Um eine weitere Glättung zu erhalten und trotzdem einem schnellem Ansteigen des Signals folgen zu können, wird die obere Hüllkurve des Signals zur Detektion der Störungen verwendet. Dies erfolgt durch einen ersten Spitzenwertgleichrichter 38, der das Additionssignal aufnimmt und als Tiefpass mit unterschiedlichen Zeitkonstanten für die ansteigende und die abfallende Flanke des Signals wirkt. Das gebildete frequenzspezifische Amplitudennäherungssignal FAM folgt entsprechend der jeweiligen Einstellung der Koeffizienten entweder der oberen Hüllkurve des Additionssignals - wenn die steigende Flanke des Filters schneller als die fallende Flanke ist - oder der unteren Hüllkurve des Additionssignals - wenn die fallende Flanke des Filters schneller als die steigende Flanke ist. Hierbei wird in dem ersten Spitzenwertgleichrichter 38 zusätzlich eine Skalierung des frequenzspezifischen Amplitudennäherungssignals FAM vorgenommen, die programmierbar ist.

In der Gleichanteil-Bestimmungseinrichtung 4 wird das Amplitudensignal AM zunächst in einem dritten Tiefpass 41 tiefpassgefiltert und zur Reduzierung des Rechenaufwandes mit der ersten Unterabtastung 1:N unterabgetastet. Für eine weitere Glättung des Signals werden in einem zweiten Spitzenwertgleichrichter 42 und einem dritten Spitzenwertgleichrichter 43 die obere bzw. untere Hüllkurve ermittelt und in der zweiten Additionseinrichtung 44 addiert, wodurch ein Mittelwert gebildet wird, der als Gleichanteilsignal GAM ausgegeben wird. Eine Halbierung der gebildeten Summe zur genauen Berechnung des Mittelwertes ist hierbei nicht erforderlich, da nachfolgend eine Normierung erfolgt.

In der frequenzhubermittelnden Einrichtung 6 wird das FM-modulierte Eingangssignal MPX zunächst in einem vierten Tiefpass 51 tiefpassgefiltert mit der ersten Unterabtastung 1:N zur Reduzierung des Rechenaufwandes und durch eine weitere Tiefpassfilterung in einem fünften Tiefpass 52 und mittels einer dritten betragsbildenden Einrichtung 53 ein drittes Betragssignal b3 gebildet. Vorteilhafterweise erfolgt anschließend eine weitere Unterabtastung in einer Unterabtastungseinrichtung 54 und eine weitere Tiefpassfilterung in einem sechsten Tiefpass 55, der das Frequenzhubsignal FH ausgibt.

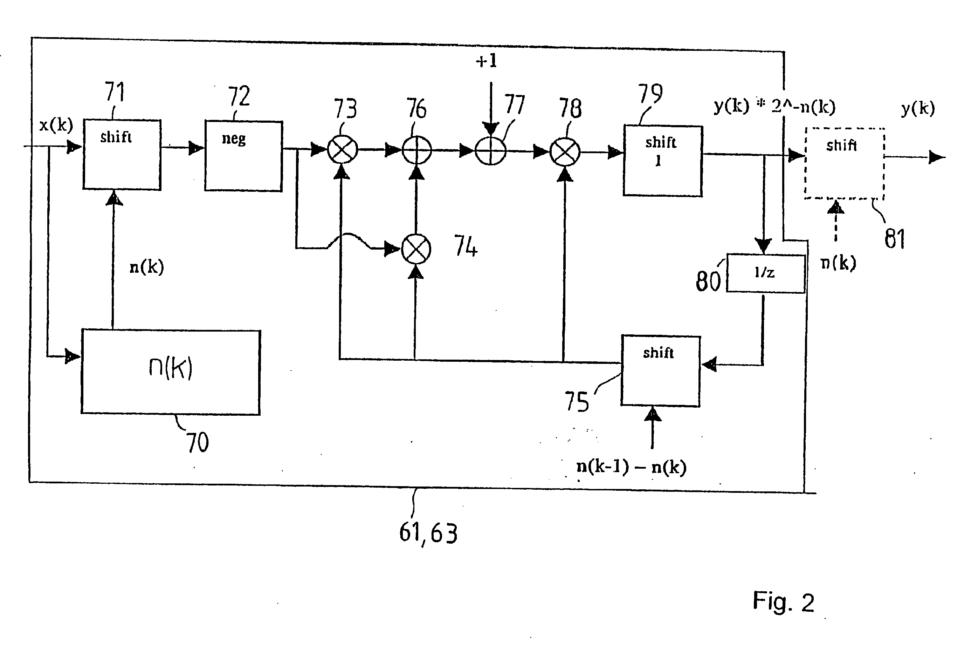

In der Normierungseinrichtung 6 wird eine Normierung des FAM auf den Gleichanteil bzw. Mittelwert und den Frequenzhub vorgenommen. Hierzu werden in Invertierungseinrichtungen 61 und 63 Näherungskehrwertsignale IG, IF des Gleichanteilsignals GAM und des Frequenzhubsignals FH gebildet, wie mit Bezug zu Fig. 2 detaillierter beschrieben wird. Die gebildeten Näherungskehrwertsignale werden in einem dritten und vierten Multiplizierer 62, 64 mit dem frequenzspezifischen Amplitudennäherungssignal FAM multipliziert. Eine weiter unten beschriebene Shiftoperation wird bei dieser Ausführungsform in einer Shift-Einrichtung 65 nach diesen Multiplikationen vorgenommen.

Eine Invertierung eines digitalen Wertes ist bei Verwendung einer echten Division sehr rechenaufwendig. Daher wird vorteilhafterweise eine Näherungsinvertierung der Signale GAM und FH durchgeführt. Hierzu kann für eine Signalfolge eines Eingangssignals x mit einem Wertebereich $0.25 \leq x \leq 1$ eine näherungsweise Invertierung $y \approx 1/(4*x)$ berechnet werden als

$$y(k) = 2*[1-2*x(k)*y(k-1)]* \ y(k-1),$$

   mit k als Index der Folge.

Zur näherungsweisen Invertierung des Frequenzhubsignals FH und des Gleichanteilsignals GAM als Eingangssignal x wird dieser Ansatz um eine Skalierung erweitert, da die betrachteten Signale einen Wertebereich $0<x\leq1$ aufweisen können. Die Skalierung erfolgt in 2er Potenzen, um sie als Shift-Operation realisieren zu können.

Für ein Signal x(k) folgt mit dem Skalierungsfaktor n(k) das skalierte Eingangssignal $x1(k) * 2^{-n(k)}$ und damit als Ausgangssignal

$$y1(k) \ \approx \ \frac{1}{4*x_1(k)} = \frac{1}{4*x(k)*2^{n(k)}} = \ y(k)*2^{-n(k)}$$

Der Skalierungsfaktor n(k) ist nicht konstant, sondern wird für jeden Eingangswert x neu bestimmt. Daher wird für die Berechnung eines neuen Ausgangswertes y(k) berücksichtigt, dass der zuvor berechnete Ausgangswert y(k-1) mit dem Skalierungsfaktor n(k-1) berechnet worden ist, während das aktuelle Eingangssignal mit dem Skalierungsfaktor n(k) skaliert wird. Damit folgt als Berechungsvorschrift:

$$y(k)*2^{-n(k)} \ = \ 2*[1-2*x(k)*2^{n(k)}*[y(k-1)*2^{-n(k-1)}]*2^{n(k-1)} \ *2^{-n(k)}]*$$
$$[y(k-1)*2^{-n(k-1)}]*2^{n(k-1)} \ *2^{-n(k)},$$

mit einem Skalierungsfaktor n(k) und k als Index der Folge

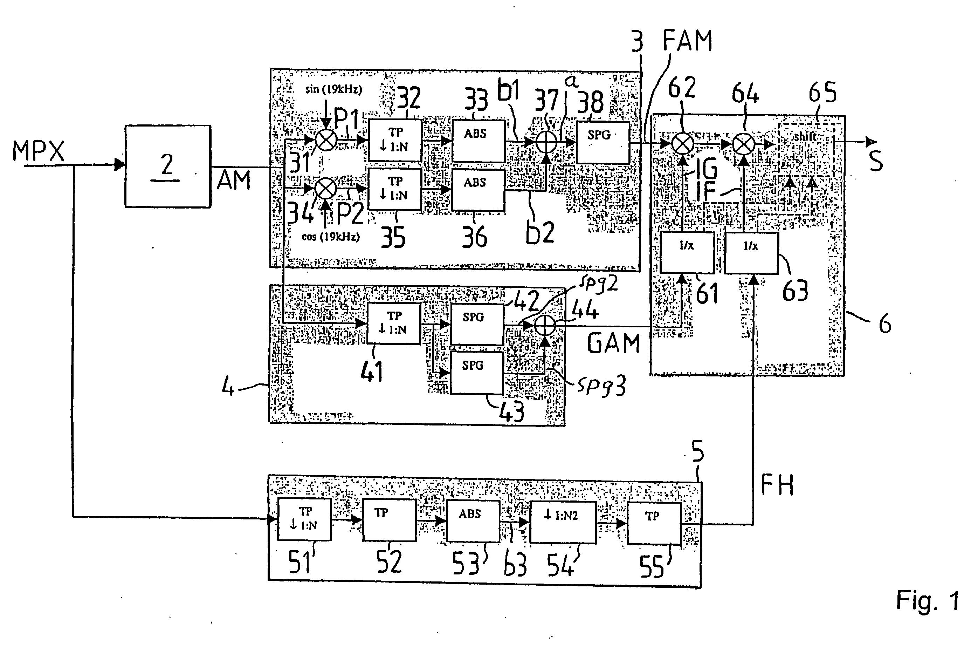

Gemäß Fig. 2 kann eine hardwaremäßige Realisierung somit erreicht werden durch eine Einrichtung 70 zur Bestimmung des Skalierungsfaktors n(k), die den Skalierungsfaktor n(k) an eine zweite Shift-Einrichtung 71 gibt, die ein eingehendes Signal x(k) entsprechend in das Ausgangssignal $x(k)*2^{n(k)}$ umwandelt, das in der Negierungseinrichtung 72 in den Faktor $(-x(k)*2^{n(k)})$ negiert wird, der wiederum in Multiplizierern 73 und 74 mit einem Ausgangssignal einer dritten Shift-Einrichtung 75 multipliziert wird. In der dritten Shift-Einrichtung 75 wird ein vorheriges Ausgangssignal y(k-1) mit dem Faktor $2^{n(k-1)} *2^{-n(k)} = 2^{n(k-1)-n(k)}$ multipliziert, so dass der Faktor $y(k-1) * 2^{n(k-1)-n(k)}$ an die Multiplizierer 73, 74 ausgegeben wird. Die identischen Ausgangssignale der Multiplizierer 73, 74 werden in einem Addierer 76 addiert, das so erhaltene Signal in einer Additionseinrichtung 77 inkrementiert und in einem Multiplizierer 78 mit dem Signal y(k-1) $* 2^{n(k-1)-n(k)}$ multipliziert und anschließend in einer Shift-Einrichtung 79 mit dem Faktor 2 multipliziert, so dass das Signal $y(k)*2^{-n(k)}$ ausgegeben wir. Dieses Signal wird in einer Shift-Einrichtung mit dem Faktor $2^{-n(k)}$ multipliziert. Hierzu ist in der Ausführungsform der Fig. 1 eine Shift-Einrichtung 65 nach den Multiplizierern 62 und 64 vorgesehen und in der Ausführungsform der Fig. 2 eine Shift-Einrichtung 81 direkt nach der Invertierung. Das Signal $y(k)*2^{-n(k)}$ wird anschließend in der Einrichtung 80 zwischengespeichert.

Hierbei wird der Skalierungsfaktor n(k) so bestimmt, dass für alle x(k), $0<x(k)\leq1$ gilt $0.25\leq x*2^{n(k)} \leq0.5$. Damit werden gegenüber der prinzipiell nur erforderlichen Skalierung auf den Wertebereich $0.25 \leq x*2^{n(k)} \leq1.0$ die durch die Skalierung auftretenden Sprünge im Eingangssignal weitgehend begrenzt. Weiterhin wird eine eindeutige Betimmung des Faktors n(k) ermöglicht.

**Patentansprüche**

**1.** Verfahren zum Detektieren von Empfangsstörungen eines digitalen FM-Empfängers, mit mindestens folgenden Schritten:

a) Demodulierung eines frequenzmodulierten digitalen Eingangssignals (MPX) in ein Amplitudensignal (AM),
b) Ermittlung eines frequenzspezifischen Amplitudennäherungssignals (FAM) aus dem Amplitudensignal (AM) für einen vorgegebenen Frequenzbereich,
c) Ermittlung eines Gleichanteilsignals (GAM) aus dem Amplitudensignal (AM),
d) Ermittlung eines Frequenzhubsignals (FH) aus dem frequenzmodulierten digitalen Eingangssignal (MPX),
e) Normierung des frequenzspezifischen Amplitudennäherungssignals (FAM) in Abhängigkeit von dem Gleichanteilsignal (GAM) und dem Frequenzhubsignal (FH) und Ausgabe eines Störungsdetektionssignals (S).

2. Verfahren nach Anspruch 1, **dadurch gekennzeichnet, dass** der vorgegebene Frequenzbereich bei einer Referenzfrequenz, vorzugsweise zwischen 17 und 20 kHz, z. B. bei etwa 19 kHz, liegt.

3. Verfahren nach Anspruch 2, **dadurch gekennzeichnet, dass** bei der Ermittlung des frequenzspezifischen Amplitudennäherungssignals (FAM) das Amplitudensignal (AM) mit mindestens einem Sinus-Hilfssignal der Referenzfrequenz, vorzugsweise 19 kHz, multipliziert wird und nachfolgend mindestens eine Tiefpassfilterung und Betragsbildung durchgeführt wird.

4. Verfahren nach Anspruch 3, **dadurch gekennzeichnet, dass** bei der Tiefpassfilterung eine erste Unterabtastung (1:N) vorgenommen wird.

5. Verfahren nach Anspruch 3 oder 4, **dadurch gekennzeichnet, dass** bei der Ermittlung des frequenzspezifischen Amplitudennäherungssignals (FAM) das Amplitudensignal (AM) mit einem ersten Sinus-Hilfssignal (sin(19kHz*t)) der Referenzfrequenz zu einem ersten Produktsignal (p1) und mit mindestens einem zu dem ersten Sinus-Hilfssignal phasenverschobenen zweiten Sinus-Hilfssignal (cos(19kHz*t)) der Referenzfrequenz zu einem zweiten Produktsignal (p2) multipliziert wird, nachfolgend aus den Produktsignalen (p1, p2) durch die Tiefpassfilterung und Betragsbildung ein erstes und zweites Betragssignal (b1, b2) ermittelt wird, und die Betragssignale (b1, b2) addiert werden, wodurch ein Additionssignal (a) gebildet wird.

6. Verfahren nach Anspruch 5, **dadurch gekennzeichnet, dass** bei der Ermittlung des frequenzspezifischen Amplitudennäherungssignals (FAM) nachfolgend eine Tiefpassfilterung des Additionssignals (a) mit unterschiedlichen Zeitkonstanten für eine ansteigende und eine abfallende Flanke vorgenommen wird.

7. Verfahren nach Anspruch 6, **dadurch gekennzeichnet, dass** die Tiefpassfilterung mit unterschiedlichen Zeitkonstanten als Spitzenwertgleichrichtung unter Ermittlung einer oberen oder unteren Hüllkurve durchgeführt wird.

8. Verfahren nach einem der vorherigen Ansprüche, **dadurch gekennzeichnet, dass** bei der Ermittlung des Gleichanteilsignals das Amplitudensignal (AM) tiefpassgefiltert wird und durch eine Spitzenwertgleichrichtung zur Ermittlung einer unteren und/oder oberen Hüllkurve mindestens ein Spitzenwertsignal (spg2, spg3) gebildet wird.

9. Verfahren nach Anspruch 8, **dadurch gekennzeichnet, dass** bei der Ermittlung des Gleichanteils die Tiefpassfilterung des Amplitudensignals (AM) mit einer Unterabtastung, vorzugsweise der ersten Unterabtastung (1:N), vorgenommen wird.

10. Verfahren nach Anspruch 8 oder 9, **dadurch gekennzeichnet, dass** eine zweite Spitzenwertgleichrichtung zur Ermittlung der unteren Hüllkurve und eine dritte Spitzenwertgleichrichtung zur Ermittlung der oberen Hüllkurve vorgenommen wird und ein ermitteltes zweites und drittes Spitzenwertsignal (spg2, spg3) addiert werden, wodurch das Gleichanteilsignal (GAM) gebildet wird.

11. Verfahren nach einem der vorherigen Ansprüche, **dadurch gekennzeichnet, dass** bei der Ermittlung des Frequenzhubsignals (FH) eine erste Tiefpassfilterung des frequenzmodulierten Eingangssignals (MPX) mit Unterabtastung, vorzugsweise der ersten Unterabtastung (1:N), nachfolgend eine zweite Tiefpassfilterung und nachfolgend eine Betragbildung durchgeführt wird, wodurch ein drittes Betragssignal (b3) gebildet wird.

12. Verfahren nach Anspruch 11, **dadurch gekennzeichnet, dass** nachfolgend eine Unterabtastung, vorzugsweise eine zweite Unterabtastung (1:N2), des dritten Betragssignals und eine weitere Tiefpassfilterung durchgeführt wird und das Frequenzhubsignal (FH) ausgegeben wird.

13. Verfahren nach einem der vorherigen Ansprüche, **dadurch gekennzeichnet, dass** bei der Normierung des frequenzspezifischen Amplitudennäherungssignals (FAM) Näherungskehrwertsignale des Gleichanteilsignals (GAM) und des Frequenzhubsignals (FH) ermittelt und mit dem frequenzspezifischen Amplitudennäherungssignal (FAM) multipliziert werden.

14. Verfahren nach Anspruch 13, **dadurch gekennzeichnet, dass** die Näherungskehrwertsignale aus einer Signalfolge des Gleichanteilsignals (GAM) und/oder des Frequenzhubsignals (FH) ermittelt werden, indem die jeweilige Signalfolge ($x_k$) in einen Wertebereich zwischen 0.25 und 1 skaliert wird und nachfolgend eine iterative Näherungsinvertierung durchgeführt wird.

15. Verfahren nach Anspruch 14, **dadurch gekennzeichnet, dass** die Skalierung der jeweiligen Signalfolge in einen Wertebereich zwischen 0.25 und 0.5 erfolgt.

16. Verfahren nach Anspruch 15, **dadurch gekennzeichnet, dass** die Skalierung als Shift-Operation durchgeführt wird.

17. Verfahren nach Anspruch 16, **dadurch gekennzeichnet, dass** die Shift-Operation nach der Näherungsinvertierung oder nach der Multiplikation mit dem frequenzspezifischen Amplitudennäherungssignal (FAM) durchgeführt wird.

18. Verfahren nach einem der Ansprüche 14 bis 17, **dadurch gekennzeichnet, dass** eine unskalierte Näherungsinvertierung $y \approx 1/(4*x)$ durchgeführt wird unter Verwendung der iterativen Rekursionsvorschrift

$$y(k)=2*[1-2*x(k)*y(k-1)]* y(k-1),$$

mit k als Index der Folge.

19. Verfahren nach Anspruch 18, **dadurch gekennzeichnet, dass** ein skaliertes Näherungskehrwertsignal y(k) ermittelt wird durch die Rekursionsvorschrift

$$y(k)*2^{-n(k)}=2*[1-2*x(k)*2^{n(k)}*[y(k-1)*2^{-n(k-1)}]*2^{n(k-1)}*2^{-n(k)}]$$
$$* [y(k-1)*2^{-n(k-1)}]*2^{n(k-1)} *2^{-n(k)},$$

mit einem Skalierungsfaktor n(k) und k als Index der Folge.

20. Vorrichtung zum Detektieren von Empfangsstörungen eines digitalen FM-Empfängers, mit
einer frequenzselektiven amplitudenermittelnden Einrichtung (3), die ein durch Demodulation eines frequenzmodulierten digitale Eingangssignals (MPX) ermitteltes Amplitudensignal (AM) aufnimmt, eine Näherung des Betrages des Amplitudensignals in einem vorgegebenen Frequenzbereich ermittelt und ein frequenzspezifisches Amplitudennäherungssignal (FAM) ausgibt, einer Gleichanteil-Bestimmungseinrichtung (4), die das Amplitudensignal (AM) aufnimmt, einen Gleichanteil ermittelt und ein Gleichanteilsignal (GAM) ausgibt,
einer frequenzhubermittelnden Einrichtung (5), die das frequenzmodulierte digitale Eingangssignal (MPX) aufnimmt, einen Frequenzhub ermittelt und ein Frequenzhubsignal (FH) ausgibt,
einer Normierungseinrichtung (6), die das frequenzspezifische Amplitudennäherungssignal (FAM), das Gleichanteilsignal (GAM) und das Frequenzhubsignal (FH) aufnimmt, das frequenzspezifische Amplitudennäherungssignal (FAM) in Abhängigkeit von dem Gleichanteilsignal (GAM) und dem Frequenzhubsignal (FH) normiert und ein Störungsdetektionsignal (S) ausgibt.

21. Vorrichtung nach Anspruch 20, **dadurch gekennzeichnet, dass** der vorgegebene Frequenzbereich bei einer Referenzfrequenz, vorzugsweise zwischen 17 und 20 kHz, z. B. bei etwa 19 kHz, liegt.

22. Vorrichtung nach Anspruch 21, **dadurch gekennzeichnet, dass** die frequenzselektive amplitudenermittelnde Einrichtung (3) mindestens aufweist einen Multiplizierer (31, 34), der das Amplitudensignal (AM) mit einem Sinus-Hilfssignal der Referenzfrequenz, vorzugsweise 19 kHz, multipliziert und ein Produktsignal (p1, p2) ausgibt, eine das Produktsignal (p1, p2) aufnehmende Tiefpasseinrichtung (32, 35) und eine ein Ausgangssignal der Tiefpasseinrichtung (32, 35) aufnehmende betragsermittelnde Einrichtung (33, 36).

23. Vorrichtung nach Anspruch 22, **dadurch gekennzeichnet, dass** die mindestens eine Tiefpasseinrichtung (32, 35) eine erste Unterabtastung (1:N) vornimmt.

**24.** Vorrichtung nach Anspruch 22 oder 23, **dadurch gekennzeichnet, dass** die frequenzselektive amplitudenermittelnde Einrichtung (3) aufweist einen ersten Multiplizierer (31), der das Amplitudensignal (AM) mit einem ersten Sinus-Hilfssignal der Referenzfrequenz multipliziert und ein erstes Produktsignal (p1) ausgibt, eine das erste Produktsignal (p1) aufnehmende erste Tiefpasseinrichtung (32), eine erste betragsermittelnde Einrichtung (33), die ein Ausgangssignal der ersten Tiefpasseinrichtung aufnimmt und ein erstes Betragssignal (b1) ausgibt, einen zweiten Multiplizierer (31, 34), der das Amplitudensignal (AM) mit einem zweiten Sinus-Hilfssignal der Referenzfrequenz multipliziert und ein zweites Produktsignal (p2) ausgibt, eine das zweite Produktsignal aufnehmende zweite Tiefpasseinrichtung (35), eine zweite betragsermittelnde Einrichtung (36), die ein Ausgangssignal der zweiten Tiefpasseinrichtung (35) aufnimmt und ein zweites Betragssignal (b2) ausgibt, und eine erste Additionseinrichtung (37), die die beiden Betragssignale (b1, b2) aufnimmt und ein Additionssignal (a) ausgibt, wobei das zweite Sinus-Hilfssignal gegenüber dem ersten Sinus-Hilfssignal phasenverschoben, vorzugsweise um 90° phasenverschoben, ist.

**25.** Vorrichtung nach Anspruch 23 oder 24, **dadurch gekennzeichnet, dass** die frequenzselektive amplitudenermittelnde Einrichtung (3) einen ersten Spitzenwertgleichrichter (38) zur Ermittlung eines Spitzenwertes einer oberen und/oder unteren Hüllkurve des Additionssignals (a) und Ausgabe des frequenzspezifischen Amplitudennäherungssignals (FAM) aufweist.

**26.** Vorrichtung nach einem der Ansprüche 20 bis 25, **dadurch gekennzeichnet, dass** die Gleichanteil-Bestimmungseinrichtung (4) einen das Amplitudensignal (AM) aufnehmenden dritten Tiefpass (41), vorzugsweise mit Unterabtastung (1:N), und mindestens einen ein Ausgangssignal des dritten Tiefpasses (41) aufnehmenden Spitzenwertgleichrichter (42, 43) zur Ermittlung der unteren und/oder oberen Hüllkurve aufweist.

**27.** Vorrichtung nach Anspruch 26, **dadurch gekennzeichnet, dass** die Gleichanteil-Bestimmungseinrichtung (4) aufweist einen zweiten Spitzenwertgleichrichter (42) und einen dritten Spitzenwertgleichrichter (43), die jeweils ein Ausgangssignal des dritten Tiefpasses (41) aufnehmen, und eine zweite Additionseinrichtung (44), die die Ausgangssignale des zweiten und dritten Spitzenwertgleichrichters (42, 43) aufnimmt und das Gleichanteilamplitudensignal (GAM) ausgibt.

**28.** Vorrichtung nach einem der Ansprüche 20 bis 27, **dadurch gekennzeichnet, dass** die frequenzhubermittelnde Einrichtung (5) aufweist einen vierten Tiefpass (51), vorzugsweise mit Unterabtastung (1:N), einen das Ausgangssignal des vierten Tiefpasses (51) aufnehmenden fünften Tiefpass (52) und eine das Ausgangssignal des fünften Tiefpasses (52) aufnehmende und ein drittes Betragssignal (b3) ausgebende dritte betragsermittelnde Einrichtung (53).

**29.** Vorrichtung nach Anspruch 28, **dadurch gekennzeichnet, dass** die frequenzhubermittelnde Einrichtung (5) eine das dritte Betragssignal (b3) aufnehmende Unterabtastungseinrichtung (54), vorzugsweise mit einer zweiten Unterabtastung (1:N2), und einen das Ausgangssignal der Unterabtastungseinrichtung (54) aufnehmenden und das Frequenzhubsignal (FH) ausgebenden sechsten Tiefpass (55) aufweist.

**30.** Vorrichtung nach einem der Ansprüche 20 bis 29, **dadurch gekennzeichnet, dass** die Normierungseinrichtung (6) Invertierungseinrichtungen (61, 63) zur Bildung von Näherungskehrwertsignalen des Gleichanteilsignals (GAM) und des Frequenzhubsignals (FH) und Multiplizierer (62, 64) zur Multiplikation des frequenzspezifischen Amplitudennäherungssignals (FAM) mit den Ausgangssignalen der Invertierungseinrichtungen (61, 63) aufweist.

**31.** Vorrichtung nach Anspruch 30, **dadurch gekennzeichnet, dass** die Invertierungseinrichtungen (61, 63) jeweils eine Einrichtung (70) zur Ermittlung eines Skalierungsfaktors (n(k)) aufweisen und die Näherungskehrwertsignale aus einer Signalfolge des Gleichanteilsignals (GAM) und/oder des Frequenzhubsignals (FH) ermitteln, indem die jeweilige Signalfolge ($x_k$) in einen Wertebereich zwischen 0.25 und 1 skaliert wird und nachfolgend eine iterative Näherungsinvertierung durchgeführt wird.

**32.** Vorrichtung nach Anspruch 31, **dadurch gekennzeichnet, dass** die Skalierung der jeweiligen Signalfolge in einen Wertebereich zwischen 0.25 und 0.5 erfolgt.

**33.** Vorrichtung nach Anspruch 32, **dadurch gekennzeichnet, dass** Shift-Einrichtungen (70, 75, 81) zur Durchführung der Skalierungen als Shift-Operationen vorgesehen sind.

**34.** Vorrichtung nach Anspruch 33, **dadurch gekennzeichnet, dass** die Shift-Operationen nach der Näherungsinvertierung oder nach der Multiplikation mit dem frequenzspezifischen Amplitudennäherungssignal (FAM) durchgeführt werden.

**35.** Vorrichtung nach einem der Ansprüche 31 bis 34, **dadurch gekennzeichnet, dass** eine unskalierte Näherungsinvertierung $y \approx 1/(4*x)$ durchgeführt wird unter Verwendung der iterativen Rekursionsvorschrift

$$y(k)=2*[1-2*x(k)*y(k-1)]* \ y(k-1),$$

mit k als Index der Folge.

**36.** Vorrichtung nach Anspruch 35, **dadurch gekennzeichnet, dass** ein skaliertes Näherungskehrwertsignal y(k) ermittelt wird durch die Rekursionsvorschrift

$$y(k)*2^{-n(k)}=2*[1-2*x(k)*2^{n(k)}*[y(k-1)*2^{-n(k-1)}]*2^{n(k-1)}*2^{-n(k)}]$$
$$*\ [y(k-1)*2^{-n(k-1)}]*2^{n(k-1)} \ *2^{-n(k)},$$

mit einem Skalierungsfaktor n(k) und k als Index der Folge.


**Claims**

**1.** Method for detecting reception interference in a digital FM receiver, having at least the following steps:

   a) demodulating a frequency-modulated digital input signal (MPX) into an amplitude signal (AM),
   b) ascertaining a frequency-specific amplitude approximation signal (FAM) from the amplitude signal (AM) for a prescribed frequency range,
   c) ascertaining a DC-component signal (GAM) from the amplitude signal (AM),
   d) ascertaining a frequency swing signal (FH) from the frequency-modulated digital input signal (MPX),
   e) normalizing the frequency-specific amplitude approximation signal (FAM) on the basis of the DC-component signal (GAM) and the frequency swing signal (FH) and outputting an interference detection signal (S).

**2.** Method according to Claim 1, **characterized in that** the prescribed frequency range is at a reference frequency, preferably between 17 and 20 kHz, e.g. at approximately 19 kHz.

**3.** Method according to Claim 2, **characterized in that** ascertaining the frequency-specific amplitude approximation signal (FAM) involves the amplitude signal (AM) being multiplied by at least one sine auxiliary signal at the reference frequency, preferably 19 kHz, and subsequently at least one low-pass filtering operation and absolute-value generation operation being performed.

**4.** Method according to Claim 3, **characterized in that** the low-pass filtering involves a first undersampling operation (1:N) being performed.

**5.** Method according to Claim 3 or 4, **characterized in that** ascertaining the frequency-specific amplitude approximation signal (FAM) involves the amplitude signal (AM) being multiplied by a first sine auxiliary signal (sin(19kHz*t)) at the reference frequency to form a first product signal (p1) and by at least one second sine auxiliary signal (cos(19kHz*t)) at the reference frequency, said second sine auxiliary signal being phase-shifted relative to the first sine auxiliary signal, to form a second product signal (p2), subsequently a first and a second absolute-value signal (b1, b2) being ascertained from the product signals (p1, p2) by the low-pass filtering and absolute-value generation, and the absolute-value signals (b1, b2) being added, which forms an addition signal (a).

**6.** Method according to Claim 5, **characterized in that** ascertaining the frequency-specific amplitude approximation signal (FAM) involves low-pass filtering of the addition signal (a) subsequently being performed with different time constants for a rising and a falling edge.

7. Method according to Claim 6, **characterized in that** the low-pass filtering with different time constants is performed as peak-value rectification to ascertain an upper or lower envelope.

8. Method according to one of the preceding claims, **characterized in that** ascertaining the DC-component signal involves the amplitude signal (AM) being subjected to low-pass filtering, and peak-value rectification to ascertain a lower and/or upper envelope forming at least one peak-value signal (spg2, spg3).

9. Method according to Claim 8, **characterized in that** ascertaining the DC component involves the low-pass filtering of the amplitude signal (AM) being performed with an undersampling operation, preferably the first undersampling operation (1:N) .

10. Method according to Claim 8 or 9, **characterized in that** a second peak-value rectification operation to ascertain the lower envelope and a third peak-value rectification operation to ascertain the upper envelope are performed and an ascertained second and third peak-value signal (spg2, spg3) are added, which forms the DC-component signal (GAM).

11. Method according to one of the preceding claims, **characterized in that** ascertaining the frequency swing signal (FH) involves a first low-pass filtering operation on the frequency-modulated input signal (MPX) with undersampling, preferably the first undersampling operation (1:N), subsequently a second low-pass filtering operation and subsequently an absolute-value generation operation being performed, which forms a third absolute-value signal (b3).

12. Method according to Claim 11, **characterized in that** subsequently an undersampling operation, preferably a second undersampling operation (1:N2), on the third absolute-value signal and a further low-pass filtering operation are performed and the frequency swing signal (FH) is output.

13. Method according to one of the preceding claims, **characterized in that** normalizing the frequency-specific amplitude approximation signal (FAM) involves approximation reciprocal signals for the DC-component signal (GAM) and for the frequency swing signal (FH) being ascertained and being multiplied by the frequency-specific amplitude approximation signal (FAM).

14. Method according to Claim 13, **characterized in that** the approximation reciprocal signals are ascertained from a signal train for the DC-component signal (GAM) and/or for the frequency swing signal (FH) by scaling the respective signal train ($x_k$) into a value range between 0.25 and 1 and subsequently performing an iterative approximation inversion operation.

15. Method according to Claim 14, **characterized in that** the respective signal train is scaled into a value range between 0.25 and 0.5.

16. Method according to Claim 15, **characterized in that** the scaling is performed as a shift operation.

17. Method according to Claim 16, **characterized in that** the shift operation is performed after the approximation inversion operation or after the multiplication by the frequency-specific amplitude approximation signal (FAM).

18. Method according to one of Claims 14 to 17, **characterized in that** an unscaled approximation inversion operation $y \approx 1/(4*x)$ is performed using the iterative recursion rule

$$y(k)=2*[1-2*x(k)*y(k-1)]*\ y(k-1),$$

with k as index for the sequence.

19. Method according to Claim 18, **characterized in that** a scaled approximation reciprocal signal y(k) is ascertained by the recursion rule

$$y(k)*2^{-n(k)}=2*[1-2*x(k)*2^{n(k)}*[y(k-1)*2^{-n(k-1)}]*2^{n(k-1)}*2^{-n(k)}]$$
$$* \; [y(k-1)*2^{-n(k-1)}]*2^{n(k-1)} \; *2^{-n(k)},$$

with a scaling factor n(k) and k as index for the sequence.

20. Apparatus for detecting reception interference in a digital FM receiver, having
a frequency-selective amplitude-ascertaining device (3) which picks up an amplitude signal (AM) ascertained by demodulating a frequency-modulated digital input signal (MPX), ascertains an approximation for the absolute value of the amplitude signal in a prescribed frequency range and outputs a frequency-specific amplitude approximation signal (FAM),
a DC-component determination device (4) which picks up the amplitude signal (AM), ascertains a DC component and outputs a DC-component signal (GAM),
a frequency-swing ascertaining device (5) which picks up the frequency-modulated digital input signal (MPX), ascertains a frequency swing and outputs a frequency swing signal (FH),
a normalization device (6) which picks up the frequency-specific amplitude approximation signal (FAM), the DC-component signal (GAM) and the frequency swing signal (FH), normalizes the frequency-specific amplitude approximation signal (FAM) on the basis of the DC-component signal (GAM) and the frequency swing signal (FH) and outputs an interference detection signal (S).

21. Apparatus according to Claim 20, **characterized in that** the prescribed frequency range is at a reference frequency, preferably between 17 and 20 kHz, e.g. at approximately 19 kHz.

22. Apparatus according to Claim 21, **characterized in that** the frequency-selective amplitude-ascertaining device (3) has at least one multiplier (31, 34) which multiplies the amplitude signal (AM) by a sine auxiliary signal at the reference frequency, preferably 19 kHz, and outputs a product signal (p1, p2), a low-pass device (32, 35) which picks up the product signal (p1, p2) and an absolute-value-ascertaining device (33, 36) which picks up an output signal from the low-pass device (32, 36).

23. Apparatus according to Claim 22, **characterized in that** the at least one low-pass device (32, 35) performs a first undersampling operation (1:N).

24. Apparatus according to Claim 22 or 23, **characterized in that** the frequency-selective amplitude-ascertaining device (3) has a first multiplier (31) which multiplies the amplitude signal (AM) by a first sine auxiliary signal at the reference frequency and outputs a first product signal (p1), a first low-pass device (32) which picks up the first product signal (p1), a first absolute-value-ascertaining device (33) which picks up an output signal from the first low-pass device and outputs a first absolute-value signal (b1), a second multiplier (31, 34) which multiplies the amplitude signal (AM) by a second sine auxiliary signal at the reference frequency and outputs a second product signal (p2), a second low-pass device (35) which picks up the second product signal, a second absolute-value-ascertaining device (36) which picks up an output signal from the second low-pass device (35) and outputs a second absolute-value signal (b2), and a first addition device (37) which picks up the two absolute-value signals (b1, b2) and outputs an addition signal (a), the second sine auxiliary signal being phase-shifted, preferably through 90°, relative to the first sine auxiliary signal.

25. Apparatus according to Claim 23 or 24, **characterized in that** the frequency-selective amplitude-ascertaining device (3) has a first peak-value rectifier (38) for ascertaining a peak value for an upper and/or lower envelope for the addition signal (a) and outputting the frequency-specific amplitude approximation signal (FAM).

26. Apparatus according to one of Claims 20 to 25, **characterized in that** the DC-component determination device (4) has a third low-pass filter (41), preferably with undersampling (1:N), which picks up the amplitude signal (AM) and at least one peak-value rectifier (42, 43), which picks up an output signal from the third low-pass filter (41), for ascertaining the lower and/or upper envelope.

27. Apparatus according to Claim 26, **characterized in that** the DC-component determination device (4) has a second peak-value rectifier (42) and a third peak-value rectifier (43), which respectively pick up an output signal from the third low-pass filter (41), and a second addition device (44), which picks up the output signals from the second and third peak-value rectifiers (42, 43) and outputs the DC-component amplitude signal (GAM).

28. Apparatus according to one of Claims 20 to 27, **characterized in that** the frequency-swing-ascertaining device (5) has a fourth low-pass filter (51), preferably with undersampling (1:N), a fifth low-pass filter (52) which picks up the output signal from the fourth low-pass filter (51) and a third absolute-value-ascertaining device (53) which picks up the output signal from the fifth low-pass filter (52) and outputs a third absolute-value signal (b3).

29. Apparatus according to Claim 28, **characterized in that** the frequency-swing-ascertaining device (5) has an undersampling device (54), preferably with a second undersampling operation (1:N2), which picks up the third absolute-value signal (b3) and a sixth low-pass filter (55) which picks up the output signal from the undersampling device (54) and outputs the frequency swing signal (FH).

30. Apparatus according to one of Claims 20 to 29, **characterized in that** the normalization device (6) has inversion devices (61, 63) for forming approximation reciprocal signals for the DC-component signal (GAM) and for the frequency swing signal (FH) and multipliers (62, 64) for multiplying the frequency-specific amplitude approximation signal (FAM) by the output signals from the inversion devices (61, 63).

31. Apparatus according to Claim 30, **characterized in that** the inversion devices (61, 63) respectively have a device (70) for ascertaining a scaling factor (n(k)) and ascertain the approximation reciprocal signals from a signal train for the DC-component signal (GAM) and/or for the frequency swing signal (FH) by scaling the respective signal train ($x_k$) into a value range between 0.25 and 1 and subsequently performing an iterative approximation inversion operation.

32. Apparatus according to Claim 31, **characterized in that** the respective signal train is scaled into a value range between 0.25 and 0.5.

33. Apparatus according to Claim 32, **characterized in that** shift devices (70, 75, 81) for performing the scaling operations are provided as shift operations.

34. Apparatus according to Claim 33, **characterized in that** the shift operations are performed after the approximation inversion operation or after the multiplication by the frequency-specific amplitude approximation signal (FAM).

35. Apparatus according to one of Claims 31 to 34, **characterized in that** an unscaled approximation inversion operation $y \approx 1/(4*x)$ is performed using the iterative recursion rule

$$y(k) = 2*[1-2*x(k)*y(k-1)]* y(k-1),$$

with k as index for the sequence.

36. Apparatus according to Claim 35, **characterized in that** a scaled approximation reciprocal signal y(k) is ascertained by the recursion rule

$$y(k)*2^{-n(k)} = 2*[1-2*x(k)*2^{n(k)}*[y(k-1)*2^{-n(k-1)}]*2^{n(k-1)}*2^{-n(k)}]$$
$$* [y(k-1)*2^{-n(k-1)}]*2^{n(k-1)} *2^{-n(k)},$$

with a scaling factor n(k) and k as index for the sequence.

**Revendications**

1. Procédé de détection des perturbations de réception dans un récepteur MF de radiodiffusion numérique comportant au moins les étapes suivantes :

   a) démodulation d'un signal de réception numérique (MPX) modulé en fréquence, pour obtenir un signal d'amplitude (AM),
   b) détermination d'un signal d'approximation d'amplitude (FAM) spécifique à la fréquence à partir du signal d'amplitude (AM) pour une plage de fréquence prédéfinie,

c) détermination d'un signal de composante continue (GAM) à partir du signal d'amplitude (AM),

d) détermination d'un signal d'excursion de fréquence (FH) à partir du signal numérique d'entrée, modulé en fréquence (MPX),

e) normalisation du signal d'approximation d'amplitude (FAM) spécifique en fréquence, en fonction du signal de composante continue (GAM) et du signal d'excursion de fréquence (FH) ainsi qu'émission d'un signal de détection de perturbations (S).

**2.** Procédé selon la revendication 1,
**caractérisé en ce que**
la plage de fréquence prédéfinie se situe à une fréquence de référence de préférence entre 17 et 20 kHz, par exemple à environ 19 kHz.

**3.** Procédé selon la revendication 2,
**caractérisé en ce qu'**
en déterminant le signal d'approximation d'amplitude spécifique en fréquence (FAM), on multiplie le signal d'amplitude (AM) avec au moins un signal auxiliaire en sinus, de la fréquence de référence, de préférence 19 kHz et ensuite on effectue un filtrage par un filtre passe-bas et on forme l'amplitude.

**4.** Procédé selon la revendication 3,
**caractérisé en ce que**
pour un filtrage passe-bas, on effectue une première sous-détection (1/N).

**5.** Procédé selon les revendications 3 ou 4,
**caractérisé en ce qu'**
en déterminant le signal d'approximation d'amplitude spécifique en fréquence (FAM) du signal d'amplitude (AM) avec un premier signal auxiliaire en sinus (sin(19kHz*t)), de la fréquence de référence pour obtenir un premier signal produit (p1) et avec au moins un second signal auxiliaire en sinus (cos(19kHz*t)), déphasé par rapport au premier signal auxiliaire en sinus à la fréquence de référence, on obtient par multiplication un second signal produit (p2), et ensuite à partir des signaux produits (p1, p2), par un filtrage passe-bas et une formation d'amplitude on détermine un premier et un second signal d'amplitude (b1, b2) et on additionne les signaux d'amplitude (b1, b2) pour former un signal d'addition (a).

**6.** Procédé selon la revendication 5,
**caractérisé en ce que**
pour la détermination du signal d'approximation d'amplitude spécifique en fréquence (FAM), on effectue ensuite un filtrage par un filtre passe-bas du signal d'addition (a) avec des constantes de temps différentes pour le flanc montant et le flanc descendant.

**7.** Procédé selon la revendication 6,
**caractérisé en ce qu'**
on effectue le filtrage par filtre passe-bas, avec des constantes de temps différentes et un écrêtage des valeurs maximales en déterminant une courbe-enveloppe supérieure ou une courbe-enveloppe inférieure.

**8.** Procédé selon l'une des revendications précédentes,
**caractérisé en ce qu'**
en déterminant le signal de composante continue du signal d'amplitude (AM) on effectue un filtrage pour un filtre passe-bas et un écrêtage de valeurs maximales on détermine un signal de valeur maximale (spg2, spg3) au moins d'une courbe-enveloppe inférieure et/ou d'une courbe-enveloppe supérieure.

**9.** Procédé selon la revendication 8,
**caractérisé en ce qu'**
en déterminant la composante continue, on effectue le filtrage passe-bas du signal d'amplitude (AM) avec une sous-détection, de préférence la première sous-détection (1/N).

**10.** Procédé selon la revendication 8 ou 9,
**caractérisé en ce qu'**
on effectue un second écrêtage de maximum en déterminant la courbe-enveloppe inférieure et un troisième écrêtage de valeurs maximales pour déterminer la courbe-enveloppe supérieure et on additionne un second et un troisième signal de valeur maximale (spg2, spg3) pour former le signal de composante continue (GAM).

11. Procédé selon l'une des revendications précédentes,
    **caractérisé en ce que**
    pour déterminer le signal d'excursion de fréquence (FH) on effectue un premier filtrage passe-bas du signal d'entrée modulé en fréquence (MPX), avec une sous-détection, de préférence la première sous-détection (1/N) et ensuite on fait un second filtrage passe-bas puis on forme une amplitude, en formant un troisième signal d'amplitude (b3).

12. Procédé selon la revendication 11,
    **caractérisé en ce qu'**
    ensuite on effectue une sous-détection, de préférence une seconde sous-détection (1/N2) du troisième signal d'amplitude et on effectue un autre filtrage passe-bas puis on émet le signal d'excursion de fréquence (FH).

13. Procédé selon l'une des revendications précédentes,
    **caractérisé en ce qu'**
    en normalisant le signal d'approximation d'amplitude spécifique en fréquence (FAM), on détermine des signaux inverses d'approximation du signal de composante continue (GAM) et du signal d'excursion de fréquence (FH) et on multiple par le signal d'approximation d'amplitude spécifique en fréquence (FAM).

14. Procédé selon la revendication 13,
    **caractérisé en ce qu'**
    on détermine les signaux de valeur inverse d'approximation à partir d'une suite de signaux du signal de composante continue (GAM) et/ou du signal d'excursion de fréquence (FH) en effectuant une mise à l'échelle de la suite de signaux respectifs ($x_k$) dans une plage de valeur comprise entre 0,25 et 1 et ensuite on effectue une inversion d'approximation par itération.

15. Procédé selon la revendication 14,
    **caractérisé en ce qu'**
    on effectue la mise à l'échelle de la suite respective de signaux dans une plage de valeur comprise entre 0,25 et 0,5.

16. Procédé selon la revendication 15,
    **caractérisé en ce qu'**
    on effectue la mise à l'échelle sous la forme d'une opération de décalage.

17. Procédé selon la revendication 16,
    **caractérisé en ce que**
    l'opération de décalage est effectuée après l'inversion d'approximation ou après multiplication par le signal d'approximation d'amplitude spécifique en fréquence (FAM).

18. Procédé selon l'une des revendications 14 à 17,
    **caractérisé en ce qu'**
    on effectue une inversion d'approximation non à l'échelle $y \approx 1/(4*x)$ en utilisant une règle de récurrence itérative

$$y(k) = 2*[1-2*x(k)*y(k-1)] * y(k-1),$$

dans laquelle k est l'indice de la suite.

19. Procédé selon la revendication 18,
    **caractérisé en ce qu'**
    on détermine un signal de valeur inverse d'approximation à l'échelle y(k) en appliquant la règle de récurrence

$$y(k)*2^{-n(k)} = 2*[1-2*x(k) * 2^{n(k)}*[y(k-1) *2^{-n(k-1)}] * 2^{n(k-1)} * 2^{-n(k)}]$$
$$* [y(k-1) *2^{-n(k-1)}] * 2^{n(k-1)} *2^{-n(k)},$$

avec un coefficient de mise à l'échelle n(k), k étant l'indice de la suite.

**20.** Dispositif de détection de perturbation de réception d'un récepteur MF numérique, comprenant
une installation de détermination d'amplitude, sélective en fréquence (3), qui reçoit un signal d'amplitude (AM) obtenu par démodulation d'un signal de réception, numérique modulé en fréquence (MPX), on détermine une approximation de l'amplitude du signal d'amplitude dans une plage de fréquence prédéfinie et on émet un signal d'approximation d'amplitude spécifique en fréquence (FAM),
une installation de détermination de composante continue (4) qui reçoit le signal d'amplitude (AM), détermine une composante continue et émet un signal de composante continue (GAM),

- une installation de détermination d'excursion de fréquence (5) recevant le signal d'entrée numérique modulé en fréquence (MPX), pour déterminer une excursion de fréquence et fournir un signal d'excursion de fréquence (FH),
- une installation de normalisation (6) qui reçoit le signal d'approximation d'amplitude spécifique en fréquence (FAM), le signal de composante continue (GAM) et le signal d'excursion de fréquence (FH), pour normaliser le signal d'approximation d'amplitude spécifique en fréquence (FAM) en fonction du signal de composante continue (GAM) et du signal d'excursion de fréquence (FH) et fournit un signal de détection de perturbations (S).

**21.** Dispositif selon la revendication 20,
**caractérisé en ce que**
la plage de fréquence prédéfinie se situe sur une fréquence de référence de préférence entre 17 et 20 kHz, par exemple à environ 19 kHz.

**22.** Dispositif selon la revendication 21,
**caractérisé en ce que**
l'installation (3) déterminant l'amplitude sélective en fréquence comporte au moins un multiplicateur (31, 34) qui multiplie le signal d'amplitude (AM) avec un signal auxiliaire en sinus, à la fréquence de référence, de préférence à 19 kHz et fournit un signal produit (p1, p2), une installation de filtre passe-bas (32, 35) recevant le signal produit (p1, p2) et une installation de détermination d'amplitude (33, 36) recevant le signal de sortie de l'installation de filtre passe-bas (32, 35).

**23.** Dispositif selon la revendication 22,
**caractérisé par**
au moins une installation de filtre passe-bas (32, 35) qui effectue une première sous-détection (1/N).

**24.** Dispositif selon les revendications 22 ou 23,
**caractérisé en ce que**
l'installation (3) de détermination d'amplitude sélective en fréquence comporte un premier multiplicateur (31) qui multiplie le signal d'amplitude (AM) avec un premier signal auxiliaire en sinus à la fréquence de référence et fournit un premier signal produit (p1), une première installation à filtre passe-bas (32) recevant le premier signal produit (p1), une première installation de détermination d'amplitude (33) qui reçoit un signal de sortie de la première installation à filtre passe-bas et fournit un premier signal d'amplitude (b1), un second multiplicateur (31, 34) qui multiplie le signal d'amplitude (AM) avec un second signal auxiliaire en sinus à la fréquence de référence et fournit un second signal produit (p2), une seconde installation de filtre passe-bas (35) qui reçoit le second signal produit, une seconde installation de détermination d'amplitude (36) recevant le signal de sortie de la seconde installation de filtre passe-bas (35) et fournissant un second signal d'amplitude (b2) et une première installation d'addition (37) recevant les deux signaux d'amplitude (b1, b2) et fournissant un signal d'addition (a), le second signal auxiliaire en sinus étant déphasé de préférence de 90° par rapport au premier signal auxiliaire en sinus.

**25.** Dispositif selon l'une des revendications 23 ou 24,
**caractérisé en ce que**
l'installation (3) déterminant l'amplitude sélective en fréquence comporte un premier écrêteur de maximum (38) pour déterminer une valeur maximale d'une courbe-enveloppe supérieure et/ou inférieure du signal d'addition (a) et fournir le signal d'approximation d'amplitude spécifique en fréquence (FAM).

**26.** Dispositif selon l'une des revendications 20 à 25,
**caractérisé en ce que**
l'installation de détermination de la composante continue (4) comporte un troisième filtre passe-bas (41) recevant le signal d'amplitude (AM), de préférence avec une sous-détection (1/N) et au moins un écrêteur de valeur maximale (42, 43) recevant le signal de sortie du troisième filtre passe-bas (41) pour déterminer la courbe-enveloppe inférieure et/ou supérieure.

**27.** Dispositif selon la revendication 26,
**caractérisé en ce que**
l'installation de détermination de la composante continue (4) comporte un second écrêteur de valeurs maximales (42) et un troisième écrêteur de valeurs maximales (43) recevant chacun un signal de sortie du troisième filtre passe-bas (41) et une seconde installation d'addition (44) qui reçoit les signaux de sortie du second et du troisième écrêteur de valeurs maximales (42, 43) pour fournir le signal d'amplitude de composante constante (GAM).

**28.** Dispositif selon l'une des revendications 20 à 27,
**caractérisé en ce que**
l'installation de détermination d'excursion de fréquence (5) comporte un quatrième filtre passe-bas (51) avec de préférence une sous-détection (1/N), un cinquième filtre passe-bas (52) recevant un signal de sortie du quatrième filtre passe-bas (51) et une troisième installation de détermination d'amplitude (53) recevant le signal de sortie du cinquième filtre passe-bas (52) et fournissant un troisième signal d'amplitude (b3).

**29.** Dispositif selon la revendication 28,
**caractérisé en ce que**
l'installation de détermination d'excursion de fréquence (5) comporte une troisième installation de sous-détection (54) recevant le troisième signal d'amplitude (b3) avec de préférence une seconde sous-détection (1/N2), et un sixième filtre passe-bas (55) recevant le signal de sortie de l'installation de sous-détection (54) et fournissant le signal d'excursion de fréquence (FH).

**30.** Dispositif selon l'une des revendications 20 à 29,
**caractérisé en ce que**
l'installation de normalisation (6) comporte des installations d'inversion (61, 63) pour former des signaux inverses d'approximation du signal de composante continue (GAM) et du signal d'excursion de fréquence (FH) ainsi que des multiplicateurs (62, 64) pour multiplier le signal d'approximation d'amplitude spécifique en fréquence (FAM) avec les signaux de sortie des installations d'inversion (61, 63).

**31.** Dispositif selon la revendication 30,
**caractérisé en ce que**
les installations d'inversion (61, 63) ont chacune une installation (70) pour déterminer un coefficient de mise à l'échelle (n(k)) et déterminer les signaux inverses d'approximation à partir d'une suite de signaux issus du signal de composante continue (GAM) et/ou du signal d'excursion de fréquence (FH) en mettant à l'échelle la suite respective de signaux ($x_k$) dans une première plage de valeur comprise entre 0,25 et 1 et en effectuant ensuite une inversion d'approximation itérative.

**32.** Dispositif selon la revendication 31,
**caractérisé en ce que**
la mise à l'échelle de la suite de signaux respectifs se fait dans une plage de valeurs comprise entre 0,25 et 0,5.

**33.** Dispositif selon la revendication 32,
**caractérisé par**
des installations de décalage (70, 75, 81) pour effectuer les mises à l'échelle sous la forme d'opérations de décalage.

**34.** Dispositif selon la revendication 33,
**caractérisé en ce que**
les opérations de décalage se font après l'inversion par approximation ou après la multiplication avec le signal d'approximation d'amplitude spécifique en fréquence (FAM).

**35.** Dispositif selon l'une des revendications 31 à 34,
**caractérisé en ce qu'**
on effectue une inversion d'approximation non à l'échelle $y \approx 1/(4 \ast x)$ en utilisant une règle de récurrence itérative

$$y(k) = 2*[1-2*x(k)*y(k-1)]*y(k-1),$$

dans laquelle k est l'indice de la suite.

**36.** Dispositif selon la revendication 35,
**caractérisé en ce que**
on détermine un signal de valeur inverse d'approximation à l'échelle y(k) en appliquant la règle de récurrence

$$y(k)*2^{-n(k)} = 2*[1-2*x(k)*2^{n(k)}*[y(k-1)*2^{-n(k-1)}]*2^{n(k-1)}*2^{-n(k)}]$$
$$*[y(k-1)*2^{-n(k-1)}]*2^{n(k-1)}*2^{-n(k)},$$

avec un coefficient de mise à l'échelle n(k), k étant l'indice de la suite.

Fig. 1

Fig. 2

EP 1 347 569 B1

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- DE 3243146